# EUROPEAN PATENT APPLICATION

(11) **EP 2 511 834 A1**
(43) Date of publication of application: **17.10.2012**
(21) Application number: 11290181.4
(22) Date of filing: 11.04.2011
(51) Int. Cl.: G06F 17/30, H03M 7/30

(54) **Method of encoding a data identifier**

(71) Applicant: Alcatel Lucent, 75007 Paris (FR)
(72) Inventor: Schwan, Nico, 70197 Stuttgart (DE); Shanbhag, Shashank, Amherst MA 01002 (DE); Rimac, Ivica, Tinton Falls NJ 07753 (US)
(74) Representative: Zinsinger, Norbert

(57) **Abstract**

The invention concerns a method of encoding a data identifier, a network unit of a data network and a computer program product to execute the said method. The data identifier is one of a plurality of data identifiers of a data network. Each of the data identifiers consists of a string of characters. An occurrence probability table is provided which indicates for defined components of the plurality of data identifiers a frequency of occurrence within the plurality of data identifiers. The components are defined based on one or more characteristics of the plurality of data identifiers. Based on the occurrence probability table, the data identifier is encoded according to a variable length encoding algorithm.

## Description

### Field of Invention

The invention relates to a method of encoding a data identifier, a network unit of a data network and a computer program product to execute the said method.

### Background

A routing of a user's data request for data within a data network such as the Internet is usually performed by network units deployed in the data network, particularly by so-called routers. A data request is specified by a data identifier such as a URI, in particular a URL (URI = Uniform Resource Identifier, URL = Uniform Resource Locator). A router usually accesses a routing table to determine an interface to which to route the data request.

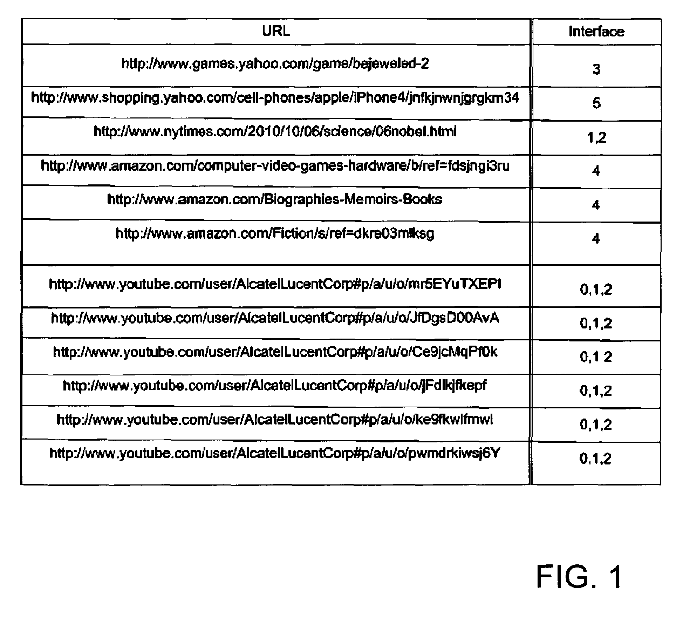

Fig. 1 shows a simplified example of a known routing table, e.g. as used in content-centric networking (= CCN). The left column of the table lists different URLs encoded in ASCII, the right column of the table lists corresponding interfaces to which to route each of the data requests (ASCII = American Standard Code for Information Interchange). The variable lengths of the ASCII URLs result in an prolonged and unpredictable lookup time of routing table entries when compared to traditional 32-bit IP addresses (IP = Internet Protocol).

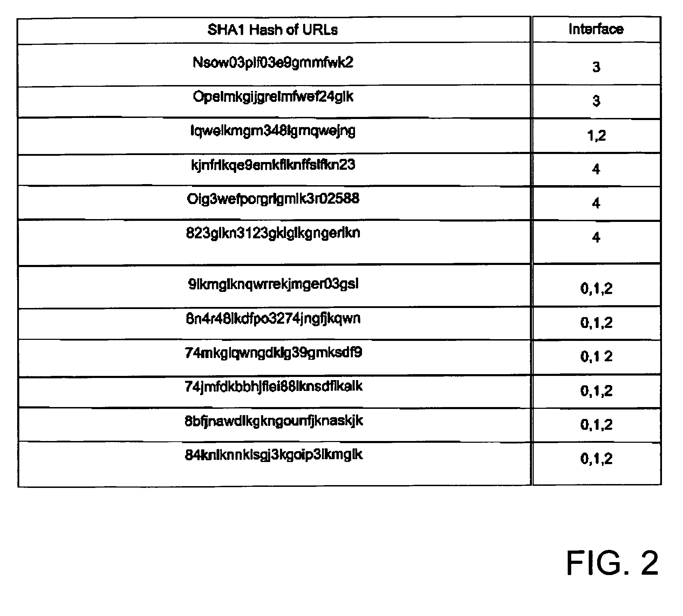

Fig. 2 shows a simplified example of an alternative known routing table where a 160-bit SHA1 hashing has been used to map the variable length URLs of Fig. 1 to a constant length value in a predefined hash space (SHA = Secure Hash Algorithm). The left column of the table lists the URLs of Fig. 1 in hashed representation, the right column of the table lists the corresponding interfaces to which to route each of the data requests, corresponding to Fig. 1. The randomness of the hashed URLs prevents any aggregation scheme and especially does not preserve the URL like structure and thus prevents prefix matching.

It is the object of the present invention to provide an improved encoding of data identifiers.

### Summary

The object of the present invention is achieved by a method of encoding a data identifier of a plurality of data identifiers of a data network, each of the data identifiers consisting of a string of characters, the method comprising the steps of providing an occurrence probability table indicating for defined components of the plurality of data identifiers a frequency of occurrence within the plurality of data identifiers, whereby the components are defined based on one or more characteristics of the plurality of data identifiers; and based on the occurrence probability table, encoding the data identifier according to a variable length encoding algorithm. The object of the present invention is further achieved by a network unit of a data network, whereby the network unit is adapted to manage requests referring to a data identifier of a plurality of data identifiers of a data network, each of the data identifiers consisting of a string of characters, whereby the network unit is further adapted to access an occurrence probability table indicating for defined components of the plurality of data identifiers a frequency of occurrence within the plurality of data identifiers, whereby the components are defined based on one or more characteristics of the plurality of data identifiers; and whereby the network unit is further adapted to encode the data identifier according to a variable length encoding algorithm, based on the occurrence probability table. And the object of the present invention is further achieved by a computer program product for encoding a data identifier of a plurality of data identifiers of a data network, each of the data identifiers consisting of a string of characters, whereby the computer program product, when executed by a network unit, performs the steps of: accessing an occurrence probability table indicating for defined components of the plurality of data identifiers a frequency of occurrence within the plurality of data identifiers, whereby the components are defined based on one or more characteristics of the plurality of data identifiers; and based on the occurrence probability table, encoding the data identifier according to a variable length encoding algorithm. One aspect of the invention is to compress data identifiers, e.g. URLs, to improve lookup speeds while preserving their structure, which helps to aggregate based on longest prefix or other schemes.

The invention constitutes a new encoding scheme for data identifiers, e.g. for URL-like content identifiers. The encoding scheme according to embodiments of the invention minimizes the number of bits needed to parse a content name, resulting in shortened lookup times. Besides a better lookup time, embodiments of the invention also allows a more efficient usage of the router memory: more routing table entries can be stored within the same amount of memory. Embodiments of the invention especially shorten lookup time of table entries in name based routers, thus providing a solution to the implementation of CCN in routers. Embodiments of the invention allow to increase lookup speeds while preserving structure. This offers the possibility to aggregate based on longest prefix or other schemes.

The increased lookup speeds rendered possible by the data identifiers encoded according to embodiments of the invention contrast with URLs encoded in ASCII, whose longer lengths (higher bit count compared to data identifiers encoded according to embodiments of the invention) lead to longer lookup times of routing table entries and next hop resolution times.

The preserved structure rendered possible by the data identifiers encoded according to embodiments of the invention contrast with hashed URLs, whose randomness prevents any aggregation scheme and especially does not preserve the URL like structure and thus prevents prefix matching. Hashing solutions may achieve a more efficient encoding, however, they do not allow for aggregation due to loss of structure that is crucial for scalability of the forwarding tables.

Further advantages are achieved by embodiments of the invention indicated by the dependent claims.

According to an embodiment of the invention, the characteristics of the plurality of data identifiers comprise:
- a frequency of occurrence of characters among the plurality of data identifiers. It has been found that the English character frequencies in URLs closely follow that of English language alphabet frequencies.
- a frequency of occurrence of sequences of components among the plurality of data identifiers. Some sequences of components are more frequent than other sequences. For example, the letter sequence "in" is more frequently found in URLs than the letter sequence "zx".
- a frequency of occurrence of pre-defined structural units of the data identifiers among the plurality of data identifiers. Structural units of a data identifier may be identifier components associated with different hierarchical levels in the case of a hierarchical data identifier, e.g. the TLD, the domain name, and an anchor tag in case of a URL (TLD = Top Level Domain). It has been found that 76.5 percent of the URLs use only a subset of all registered (about 300) TLDs: com, net, de, ru, and org.
- an average number of characters in the strings of characters constituting the data identifiers. The average domain length is fifteen characters.
- the number of different characters available for composing a data identifier. According to RFC 1738, URLs can only be encoded using seventy-three characters (0-9, a-z, A-Z, and the special characters $ - _ . + ! * ' ( ) , ).
- the type of characters available for composing a data identifier. It is possible that a class of data identifiers allows only upper case letters.
- a frequency of usage of a data identifier within at least a part of the data network. Some data identifiers, e.g. "http://www.google.com", are more frequently used in the Internet than others.

The encoding may exploit one or more of these characteristics of the plurality of data identifiers. For example, given the fact that the TLD "com" is much more frequent among the plurality of data identifiers than the TLD "tl", it is advantageous for an encoding scheme to allocate a single encoding symbol to the TLD "com" but to encode the TLD "tl" as a sequence of the letters "t" and "I". According to an embodiment of the invention, the data identifier is encoded by separating the data identifier into a sequence of one or more of the defined components, allocating to the one or more defined components of the data identifier a bit representation according to the variable length encoding algorithm, and converting the sequence of the one or more components of the data identifier to a sequence of the allocated bit representations.

For example, the URL "http://www.youtube.com/user/AlcatelLucentCorp#p/a/u/0/mr5EYuTXEPI" comprises components, e.g. the domain name and a TLD, which are relatively frequent in the Internet while other components are not so frequent. Since it has been found that the component "http://www.youtube" has a relatively high frequency of occurrence in the data network concerned, namely the Internet, it is justified to allocate a unique symbol to this component. The same holds for the components "com", "AlcatelLucentCorp" and the anchor tag "#". On the other hand, the symbol allocation in respect of the characters following the "#" will depend on the frequency of occurrence of the individual characters.

According to an embodiment of the invention, the data identifiers are URIs, in particular URLs. In the Internet, URIs are the most popular data identfiers. However, in a private data network, another data identifier type may be used instead.

According to an embodiment of the invention, the variable length encoding algorithm is based on Huffman, Shannon-Fano or arithmetic coding. The resulting representation of the data identifier may be a binary code, i.e. using the two binary digits 0 and 1.

According to an embodiment of the invention, the data identifiers are URLs, the defined components comprise TLDs with the greatest frequency of occurrence among the plurality of URLs, URL names with the greatest frequency of occurrence among the plurality of URLs and the single characters available according to RFC 1738, and the data identifier is encoded to a bit code according to a variable length encoding algorithm, preferably the Huffman encoding (RFC = Request for Comments).

According to this embodiment of the invention, URL characteristics are used to define symbols useable in a variable length encoding algorithm. Preferably, these URL characteristics may be a popularity of the TLDs of the URLs, a popularity of URL names of the URLs, and the fact that URLs are constructed only out of a subset (seventy-three characters) of all possible characters. Then, probabilities with respect to the frequency a certain symbol occurs are assigned to each symbol. Next, a variable length encoding scheme, e.g. the Huffman encoding, is applied to create a bit code representation of the URL.

According to another embodiment of the invention, the network unit is further adapted to decode the encoded data identifier back to its original string-of-characters representation, based on the occurrence probability table. It is possible that the network unit receives an incoming data request, encodes the data identifier associated with the data request according to an embodiment of the inventive method and looks up in its routing table which comprises a list of data identifiers and associated routing addresses. In order to ensure compatibility, the data identifiers in the routing table have been encoded by the same encoding method that is used by the router. After identifying the appropriate routing address in the routing table, the network unit decodes the encoded data identifier again and routes the data request in decoded form, i.e. as originally received, to the routing address. Therefore, it is possible that the method is only applied internally in a network unit, allowing each network unit to optimize symbol and probability assignment according to its own needs.

According to another embodiment of the invention, the network unit is a router.

There are different deployment possibilities for the method:
One possibility is that the protocol between routers uses the method, thus all routers need to use the same symbol and probability assignment scheme. Thus, according to an embodiment of the invention, the network unit is adapted to access the occurrence probability table as one of several network units of the data network.
In another deployment the method is only applied internally in a router, thus each router can optimize symbol and probability assignment according to its own needs. Thus, according to an embodiment of the invention, the network unit is further adapted to maintain the occurrence probability table as a resource accessible only by the network unit.

According to another embodiment of the invention, the network unit comprises the occurrence probability table. This means that the occurrence probability table is stored in a storage unit of the network unit.

### Brief Description of the Figures

These as well as further features and advantages of the invention will be better appreciated by reading the following detailed description of exemplary embodiments taken in conjunction with accompanying drawings of which:
- Fig. 3: shows an occurrence probability table according to an embodiment of the invention;
- Fig. 4: shows a Huffman encoding scheme of the data identifiers according to an embodiment of the invention;
- Fig. 5: shows a bit code table according to an embodiment of the invention.
- Figs. 6 to 8: give a comparison of the bitcount of a standard ASCII URL encoding (Fig. 6), a SHA1 URL encoding (Fig. 7) and a variable length encoding according to an embodiment of the invention (Fig. 8); and
- Fig. 9: shows a diagram of a CCN router according to an embodiment of the invention.

### Description of the Embodiments

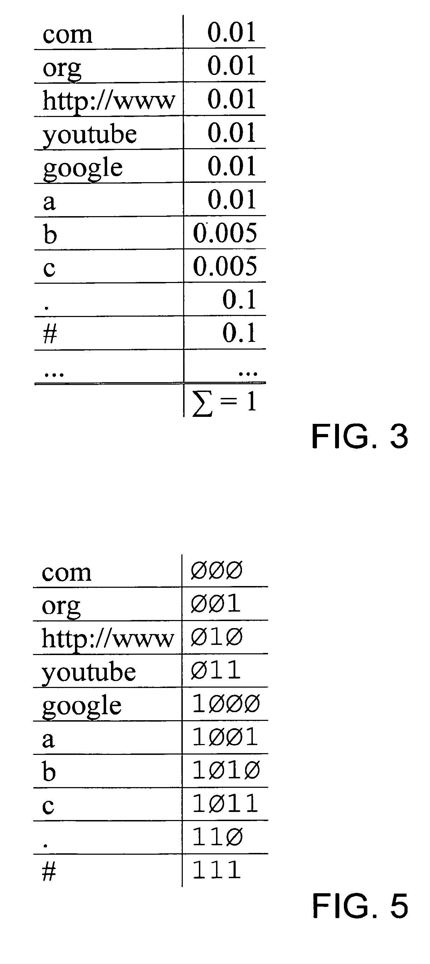

Fig. 3 shows an occurrence probability table for use in an encoding scheme which aims to minimizes the number of bits needed to parse a data identifier, e.g. a content name. Besides a better lookup time this also allows a more efficient usage of the router memory, since more routing table entries can be stored with the same amount of memory.

The left column of the table lists components of URLs wherein the components have been chosen having regard to characteristics of URLs such as:
- the frequency of occurrences of characters
- request patterns, meaning that some content items/ domain names are more popular than others
- most URLs are constructed using only a subset of TLDs
- the average length of URLs
- the fact that URLs consist of seventy-three different characters only.

Based on previous studies on URL lengths, URL character and TLD distributions, domain popularity, etc., the following lists some of the characteristics of URLs:
- Average URL length is fifty-eight characters.
- Average domain length is fifteen characters.
- 76.5 percent of the URLs have the following TLDs: com, net, de, ru and org.
- There are about three hundred TLDs in total
- The English character frequencies in URLs closely follow that of English language alphabet frequencies.

The right column of the table lists relative probabilities of the components, having regard to the plurality of URLs. The sum of all relative probabilities of all components available for the variable length encoding is equal to one, as is indicated in the last line of the right column. In the language of variable length encoding, the components are known as "symbols".

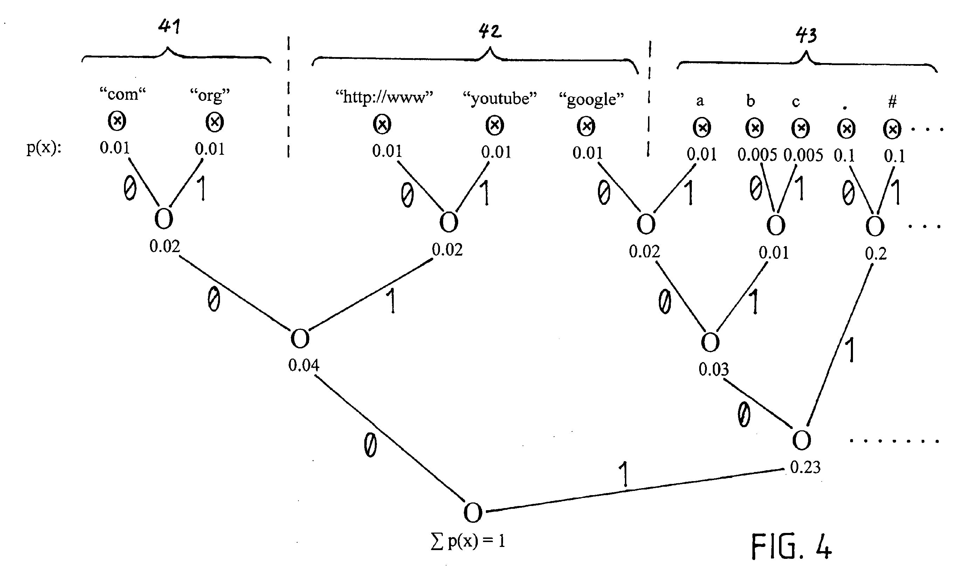

Fig. 4 illustrates an encoding array that makes use of the frequency of occurrences. For this example, a Huffman coding array is used. The pre-defined components, i.e. the symbols marked by an "x", correspond to the components of the occurrence probability table of Fig. 3. The components have been classified in a first class 41 comprising frequently used TLDs, a second class 42 comprising frequently used domain names, and a third class 43 comprising the seventy-three characters available for creating a URL.

Below each symbol x, the corresponding relative probability p(x), also known as "weight", is listed. Starting from the symbols and their associated weight, a binary tree is generated according to the Huffman encoding. Fig. 4 shows only a part of the entire binary tree, as is indicated by the ellipsis dots at the right edge of the scheme. The entire binary tree gives a sum weight of one: Σ p(x) = 1.

Fig. 5 shows a bit code table listing the bit codes for the components ("symbols") of the occurrence probability table of Fig. 3. It is apparent that more frequently used components have less bits than more rarely used components. This is an illustration that the data identifier encoding scheme according to the invention minimizes the number of bits needed to parse a data identifier, resulting in shortened lookup times at a parsing network unit.

Based on this bit code table, a URL can be re-composed from its components and represented as a bit code. For example, the ASCII-coded URL "hftp://www.google.com" would have the following bit code representation when encoded according to the bit code table of Fig. 5: "0101101000110000".

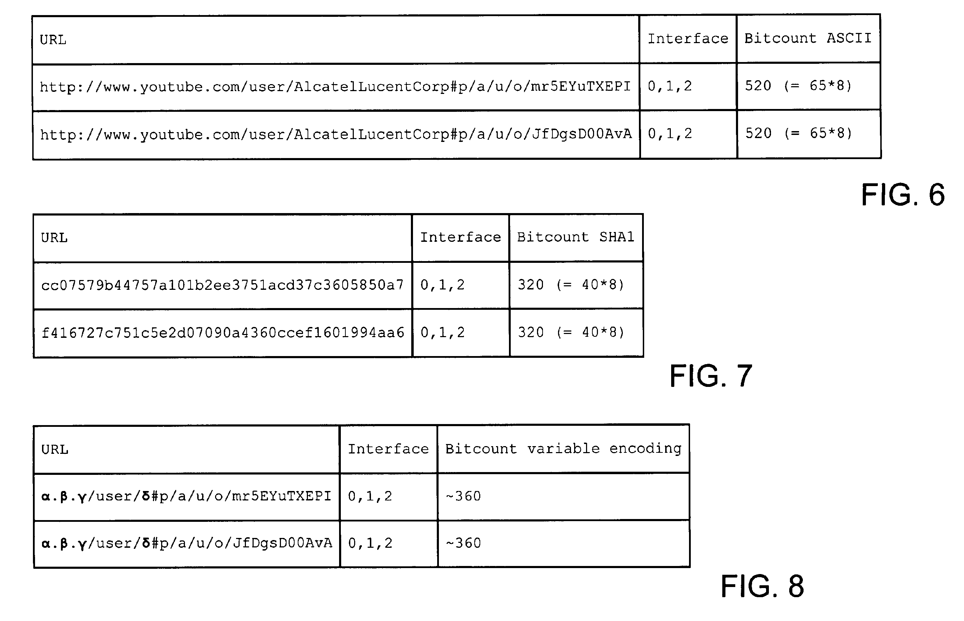

Figs. 6 to 8 give a comparison of the bit count resulting from different encodings of two URLs. It is to be noted that the final binary bit code representation after applying the encoding schemes is not illustrated. Instead the figures are limited to show the final binary bit count only. For the variable encoding the bit count is only one possible result showing the benefits of the invention.

Fig. 6 shows two URLs, each with a length of 65 characters, in ASCII encoding.

The URLs differ only in their last eleven characters. The bit count of each of these URLs is 65 characters x 8 bit/character = 520 bit. The advantage of ASCII encoded URLs is the possibility of aggregation.

Fig. 7 shows the two URLs of Fig. 6, but in a SHA1 encoding which reduces the URL to a length of 40 characters. Consequently, the bit count of each of these URLs is 40 characters x 8 bit/character = 320 bit. Although SHA1 encoding significantly reduces the bit count compared to ASCII encoding, SHA1 encoding loses the possibility of aggregation.

Fig. 8 shows the two URLs of Fig. 6, but in a variable length encoding according to an embodiment of the invention. The following component (= symbol) definitions are used:
http://www = α
youtube = β
com = γ
AlcatelLucentCorp = δ

The variable length encoding reduces the URL to a length of 32 components. As was illustrated in Fig. 5, each component can have a different bit length. Therefore, the simple calculation 32 components x 8 bit/component = 256 bit would be wrong in this case. It can be shown that the bit count of each of these URLs in the variable length encoding according to an embodiment of the invention is about 360 bit. Thus, the bit count is lower compared to ASCII encoding, but higher compared to SHA1 encoding.

Although the variable length encoding according to the invention leads to a slightly higher bit count compared to a SHA1 encoding, it has the significant advantage over the SHA1 encoding that is preserves the structure of the data identifier, here: the URLs.

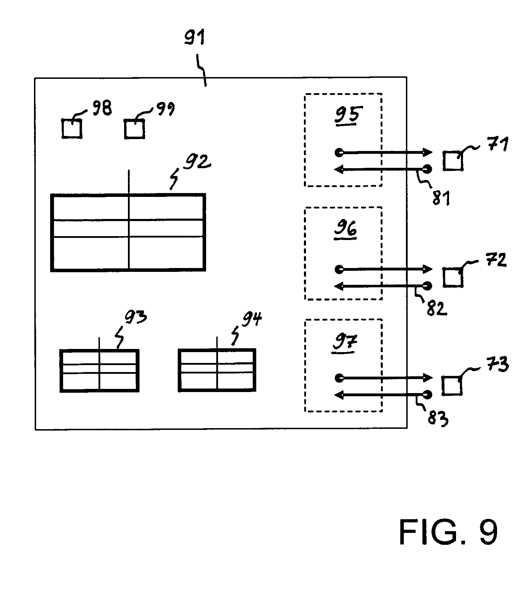

Fig. 9 shows a router 91 of a CCN data network. The router 91 comprises a FIB 92, a content store 93, a PIT 94, three interfaces 95, 96, 97, a storage unit 98, and a processing unit 99 (FIB = Forwarding Information Base; PIT = Pending Interest Table). The FIB is equivalent to a routing table. The router 91 is adapted to communicate via its interfaces 95, 96, 97 with other network units 71, 72, 73, e.g. a mobile unit 71, an Internet based unit 72, and an application 73. From each of the other network units 71, 72, 73 the router 91 can receive requests 81, 82, 83 referring to a data identifier of a plurality of data identifiers of the data network.

The network unit 91 is adapted to access an occurrence probability table indicating for defined components of the plurality of data identifiers a frequency of occurrence within the plurality of data identifiers. It is possible that the network unit 91 comprises the occurrence probability table, i.e. that the occurrence probability table is stored in the storage unit 98 of the network unit 91. It is also possible that network unit 91 accesses a preferably externally deployed occurrence probability table as one of several routers of the data network.

After receiving one of the requests 81, 82, 83, the router 91 determines the data identifier specified in the request and separates the determined data identifier according to components listed in the occurrence probability table.

Based on the occurrence probability table, the router 91 encodes the data identifier according to a variable length encoding algorithm, e.g. by means of the processing unit 99.

The processing unit 99 is composed of one or several inter-linked computers, i.e. a hardware platform, a software platform basing on the hardware platform and several application programs executed by the system platform formed by the software and hardware platform. The functionality of the processing unit 99 are provided by the execution of these application programs. The application programs or a selected part of these application programs constitute a computer software product providing an encoding service as described in the following, when executed on the system platform. Further, such computer software product is constituted by the storage medium 98 storing these application programs or said selected part of application programs.

The computer program product for encoding the data identifier of the plurality of data identifiers of the data network, each of the data identifiers consisting of a string of characters, when executed by the processing unit 99 of the router 91, performs the steps of accessing the occurrence probability table indicating for defined components of the plurality of data identifiers a frequency of occurrence within the plurality of data identifiers, whereby the components are defined based on one or more characteristics of the plurality of data identifiers; and based on the occurrence probability table, encoding the data identifier according to a variable length encoding algorithm.

By means of the encoded data identifier, the router 91 parses the FIB 92 to determine the appropriate interface 95, 96, 97 from which the data request 81, 82, 83 is to be routed. After identification of the appropriate interface 95, 96, 97, the router 91 routes the data request 81, 82, 83 from the identified interface 95, 96, 97 to another network unit 71, 72, 73.

## Claims

1. A method of encoding a data identifier of a plurality of data identifiers of a data network, each of the data identifiers consisting of a string of characters, the method comprising the steps of:
providing an occurrence probability table indicating for defined components of the plurality of data identifiers a frequency of occurrence within the plurality of data identifiers, whereby the components are defined based on one or more characteristics of the plurality of data identifiers; and
based on the occurrence probability table, encoding the data identifier according to a variable length encoding algorithm.

2. The method according to claim 1,
**characterised in**
**that** the characteristics of the plurality of data identifiers comprise:
- a frequency of occurrence of characters among the plurality of data identifiers;
- a frequency of occurrence of sequences of components among the plurality of data identifiers;
- a frequency of occurrence of pre-defined structural units of the data identifiers among the plurality of data identifiers;
- an average number of characters in the strings of characters constituting the data identifiers;
- the number of different characters available for composing a data identifier;
- the type of characters available for composing a data identifier; and
- a frequency of usage of a data identifier within at least a part of the data network.

3. The method according to claim 1,
**characterised in**
**that** the data identifier is encoded by separating the data identifier into a sequence of one or more of the defined components, allocating to the one or more defined components of the data identifier a bit representation according to the variable length encoding algorithm, and converting the sequence of the one or more components of the data identifier to a sequence of the allocated bit representations.

4. The method according to claim 1,
**characterised in**
**that** the data identifiers are URIs.

5. The method according to claim 1,
**characterised in**
**that** the variable length encoding algorithm is based on Huffman, Shannon-Fano or arithmetic coding.

6. The method according to claim 1,
**characterised in**
**that** the data identifiers are URLs, that the defined components comprise TLDs with the greatest frequency of occurrence among the plurality of URLs, URL names with the greatest frequency of occurrence among the plurality of URLs and the single characters available according to RFC 1738, and that the data identifier is encoded to a bit code according to a variable length encoding algorithm, preferably the Huffman encoding.

7. A network unit (91) of a data network, whereby the network unit (91) is adapted to manage requests (81, 82, 83) referring to a data identifier of a plurality of data identifiers of a data network, each of the data identifiers consisting of a string of characters, whereby the network unit (91) is further adapted to access an occurrence probability table indicating for defined components of the plurality of data identifiers a frequency of occurrence within the plurality of data identifiers, whereby the components are defined based on one or more characteristics of the plurality of data identifiers; and whereby the network unit (91) is further adapted to encode the data identifier according to a variable length encoding algorithm, based on the occurrence probability table.

8. The network unit (91) according to claim 7,
**characterised in**
**that** the network unit (91) is further adapted to decode the encoded data identifier back to its original string-of-characters representation, based on the occurrence probability table.

9. The network unit (91) according to claim 7,
**characterised in**
**that** the network unit (91) is a router.

10. The network unit (91) according to claim 7,
**characterised in**
**that** the network unit (91) is further adapted to maintain the occurrence probability table as a resource accessible only by the network unit (91).

11. The network unit (91) according to claim 7,
**characterised in**
**that** the network unit (91) comprises the occurrence probability table.

12. The network unit (91) according to claim 7,
**characterised in**
**that** the network unit (91) is adapted to access the occurrence probability table as one of several network units of the data network.

13. A computer program product for encoding a data identifier of a plurality of data identifiers of a data network, each of the data identifiers consisting of a string of characters, whereby the computer program product, when executed by a network unit, performs the steps of:
accessing an occurrence probability table indicating for defined components of the plurality of data identifiers a frequency of occurrence within the plurality of data identifiers, whereby the components are defined based on one or more characteristics of the plurality of data identifiers; and
based on the occurrence probability table, encoding the data identifier according to a variable length encoding algorithm.

## Amended claims

### Amended claims in accordance with Rule 137(2) EPC.

**1.** A method of encoding a data identifier of a plurality of data identifiers of a data network, each of the data identifiers consisting of a string of characters, the method comprising the steps of:
providing an occurrence probability table indicating for defined components of the plurality of data identifiers a frequency of occurrence within the plurality of data identifiers, whereby the components are defined based on one or
more characteristics of the plurality of data identifiers, whereby a single encoding symbol is allocated to a component which has a high frequency of occurrence in the data network; and
based on the occurrence probability table, encoding the data identifier according to a variable length encoding algorithm.

**2.** The method according to claim 1,
**characterised in**
**that** the characteristics of the plurality of data identifiers comprise:
- a frequency of occurrence of characters among the plurality of data identifiers;
- a frequency of occurrence of sequences of components among the plurality of data identifiers;
- a frequency of occurrence of pre-defined structural units of the data identifiers among the plurality of data identifiers;
- an average number of characters in the strings of characters constituting the data identifiers;
- the number of different characters available for composing a data identifier;
- the type of characters available for composing a data identifier; and
- a frequency of usage of a data identifier within at least a part of the data network.

**3.** The method according to claim 1,
**characterised in**
**that** the data identifier is encoded by separating the data identifier into a
sequence of one or more of the defined components, allocating to the one or more defined components of the data identifier a bit representation according to the variable length encoding algorithm, and converting the sequence of the one or more components of the data identifier to a sequence of the allocated bit representations.

**4.** The method according to claim 1,
**characterised in**
**that** the data identifiers are URls.

**5.** The method according to claim 1,
**characterised in**
**that** the variable length encoding algorithm is based on Huffman, Shannon-Fano or arithmetic coding.

**6.** The method according to claim 1,
**characterised in**
**that** the data identifiers are URLs, that the defined components comprise TLDs with the greatest frequency of occurrence among the plurality of URLs, URL names with the greatest frequency of occurrence among the plurality of URLs and the single characters available according to RFC 1738, and that the data identifier is encoded to a bit code according to a variable length encoding algorithm, preferably the Huffman encoding.

**7.** A network unit (91) of a data network, whereby the network unit (91) is adapted to manage requests (81, 82, 83) referring to a data identifier of a plurality of data identifiers of a data network, each of the data identifiers consisting of a string of characters, whereby the network unit (91) is further adapted to access an occurrence probability table indicating for defined components of the plurality of data identifiers a frequency of occurrence within the plurality of data identifiers, whereby the components are defined based on one or more characteristics of the plurality of data identifiers, whereby a single encoding symbol is allocated to a component which has a high frequency of occurrence in the data network; and whereby the network unit (91) is further adapted to encode the data identifier according to a variable length encoding algorithm, based on the occurrence probability table.

**8.** The network unit (91) according to claim 7,
**characterised in**
**that** the network unit (91) is further adapted to decode the encoded data identifier back to its original string-of-characters representation, based on the occurrence probability table.

**9.** The network unit (91) according to claim 7,
**characterised in**
**that** the network unit (91) is a router.

**10.** The network unit (91) according to claim 7,
**characterised in**
**that** the network unit (91) is further adapted to maintain the occurrence probability table as a resource accessible only by the network unit (91).

**11.** The network unit (91) according to claim 7,
**characterised in**
**that** the network unit (91) comprises the occurrence probability table.

**12.** The network unit (91) according to claim 7,
**characterised in**
**that** the network unit (91) is adapted to access the occurrence probability table as one of several network units of the data network.

**13.** A computer program product for encoding a data identifier of a plurality of data identifiers of a data network, each of the data identifiers consisting of a string of characters, whereby the computer program product, when executed by a network unit, performs the steps of:
accessing an occurrence probability table indicating for defined components of the plurality of data identifiers a frequency of occurrence within the plurality of data identifiers, whereby the components are defined based on one or
more characteristics of the plurality of data identifiers, whereby a single encoding symbol is allocated to a component which has a high frequency of occurrence in the data network; and
based on the occurrence probability table, encoding the data identifier according to a variable length encoding algorithm.
